# EUROPEAN PATENT SPECIFICATION

(11) **EP 4 174 445 B1**
(45) Date of publication and mention of the grant of the patent: **16.07.2025**
(21) Application number: 21846287.7
(22) Date of filing: 28.05.2021
(51) Int. Cl.: H03K 17/97, G01D 5/244, G01D 5/245, G01B 7/30, G01D 5/14

(54) **POSITION DETECTION DEVICE**
POSITIONSDETEKTIONSVORRICHTUNG
DISPOSITIF DE DÉTECTION DE POSITION

(30) Priority: 20.07.2020 JP 2020124015
(43) Date of publication of application: 03.05.2023
(73) Proprietor: METROL CO., LTD., Tachikawa-shi Tokyo 190-0011 (JP)
(72) Inventor: YOSHIOKA, Takamoto, Tachikawa-shi, Tokyo 190-0011 (JP); KANNO, Takayuki, Tachikawa-shi, Tokyo 190-0011 (JP)
(74) Representative: Ström & Gulliksson AB
(86) International application number: PCT/JP2021/020416
(87) International publication number: WO 2022/018969

(56) References cited:
- WO-A1-2020/158677
- JP-A- 2001 221 608
- JP-A- 2008 101 932
- JP-A- 2010 096 540
- JP-A- 2010 197 373
- JP-A- 2011 169 696
- JP-A- 2011 220 832
- JP-A- H09 229 612
- JP-A- S6 183 710
- JP-B2- 5 144 694
- JP-B2- 5 155 966
- US-A1- 2007 096 723
- US-B2- 7 843 190

## Description

### TECHNICAL FIELD

The present invention relates to position detection devices, and more particularly relates to a position detection device that detects a position of a movable body.

### BACKGROUND ART

For example, in machine tools such as machining centers, there is a need to detect an initial position of the tool in order to achieve precise machining. As a position detection device that detects a position of a movable body that is moved by an object to be detected, such as a tool, a device wherein an electric contact point is mechanically switched on or off according to the movement of the movable body is known (for example, see Patent Document 1).

However, in such a conventional position detection device, there is a problem that the contact point deteriorates with repeated mechanical on/off switching, and thus has a short lifespan. There is also a problem that the intrusion of foreign objects or the formation of oxide films cause poor conductivity between contact points, and that detection precision is reduced due to wear and denting of the contact points due to repeated contact.

Patent Document 1: Japanese Unexamined Patent Application, Publication No. 2008-183699

US 7 843 190 B2 discloses a position detection apparatus. A magnetic flux detection unit and a rectangular solid magnet are provided. The magnetic flux detection unit includes one or more pairs of Hall sensors, each pair having two Hall sensors arranged on a substrate. The solid magnet is arranged movably in a direction in a plane parallel to the substrate. Each pair of two Hall sensors is arranged on the substrate so that a line connecting the centers of magnetism sensing sections of each pair of two Hall sensors is orthogonal to a movement direction of the magnet. A tetragon has a long side and a short side and the long side has an inclination angle to the line connecting the centers of magnetism sensing sections of the each pair of two Hall sensors. The magnet has one N-pole and one S-pole separately magnetized in orthogonal to the substrate on which the Hall sensors are arranged.

JP 5 144694 B2 discloses a magnetic sensor unit. Voltage/current (V/I) conversion sections for performing V/I conversion of sensor outputs are provided upstream of a subtraction section for calculating a difference signal of the sensor outputs. An addition section for calculating a sum signal of the sensor outputs is provided. The V/I conversion sections are switched with a predetermined period, and as a result, an average value of divided values of the difference signal and sum signal obtained by treating the sensor outputs with the V/I conversion sections is outputted as a position detecting signal.

JP 5 155966 B2 discloses a position detector. The position detector comprises at least one pair of magnetic sensors disposed and spaced from each other, a magnet disposed so as to be movable and inclinable to the magnetic sensor pair, a V/I conversion circuit for converting output voltages of the magnetic sensors into currents, a subtraction circuit for generating a differential current based on the currents converted by the V/I conversion circuit, an addition circuit for generating an addition current based on the currents converted by the V/I conversion circuit, a current division circuit for dividing the differential current by the addition current, and an output circuit for outputting a value obtained by a division in the current division circuit as a position signal.

### DISCLOSURE OF THE INVENTION

### Problems to be Solved by the Invention

The present invention was made in view of these problems of the conventional art, and has an object of providing a position detection device that can stably detect a position with high detection precision over a long lifespan.

### Means for Solving the Problems

According to an aspect of the present invention, a position detection device that can stably detect a position with high detection precision over a long lifespan is provided. This position detection device is provided with a magnet configured to move, together with a movable body, on a movement path extending along a first direction. The magnet has different magnetic poles in a second direction that is perpendicular to the first direction. The position detection device is also provided with a pair of magnetic sensors that are separated by equal distances, in the second direction, from the movement path, and that are disposed at equal distances from a reference line extending in the second direction. The pair of magnetic sensors have identical sensor characteristics. The position detection device is also provided with a detection unit configured to detect that the magnet is positioned on the reference line in a state where absolute values of output change rates of both of the pair of magnetic sensors are maximum.

### BRIEF DESCRIPTION OF THE DRAWINGS

Fig. 1 is a schematic view of a position detection device according to an embodiment of the present invention;
Fig. 2 is a graph illustrating a relationship between a position of a magnet and an output of a magnetic sensor according to an embodiment of the present invention;
Fig. 3 is a graph illustrating a temperature-induced change of the output of the magnetic sensor according to an embodiment of the present invention;
Fig. 4 is a graph illustrating a relationship between a shape of the magnet and a maximum magnetic flux according to an embodiment of the present invention;
Fig. 5 is a graph illustrating a relationship between a thickness of a magnet and a magnetic flux density according to an embodiment of the present invention;
Fig. 6 illustrates a positional relationship between a track displacement of the magnetic sensor and the magnet according to an embodiment of the present invention;
Fig. 7 is a graph illustrating a relationship between a displacement of a magnetic sensor in a track direction and an output distribution according to an embodiment of the present invention;
Fig. 8 is a graph illustrating a relationship between a position of a magnet and an output change rate of a magnetic sensor according to an embodiment of the present invention; Fig. 9 is a graph illustrating a relationship between a distance (gap) between a magnetic sensor and a magnet and a magnetic flux density according to an embodiment of the present invention
Fig. 10 is a graph illustrating a relationship between a distance in an X direction centered on a detection point and an output according to an embodiment of the present invention; Fig. 11 is a graph illustrating a relationship between a distance in an X direction centered on a detection point and an actual value of an output change rate according to an embodiment of the present invention;
Fig. 12 illustrates a change in an internal sensor value as internal data when a position detection device 1 is functioning normally;
Fig. 13 illustrates a change in an internal sensor value as internal data when a position detection device 1 is in an abnormal state due to a return failure; and
Fig. 14 illustrates a change in an internal sensor value as internal data when a position detection device 1 is in an abnormal state due to a deteriorated bearing.

### PREFERRED MODE FOR CARRYING OUT THE INVENTION

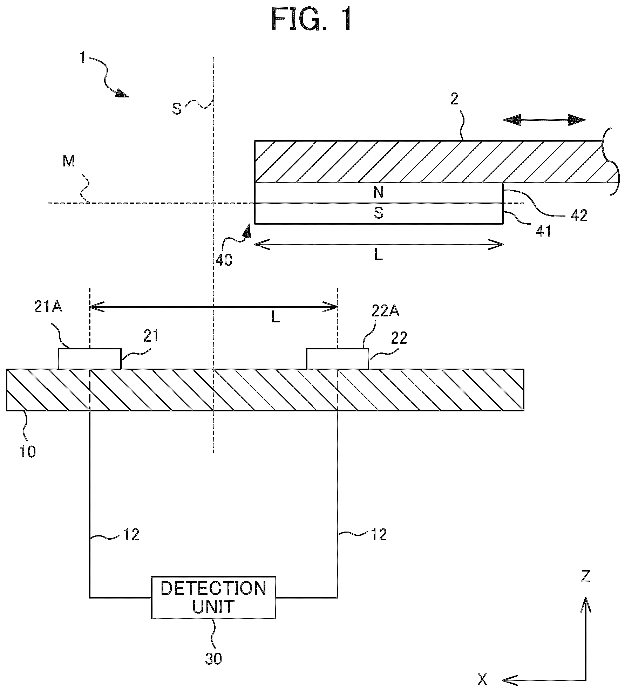

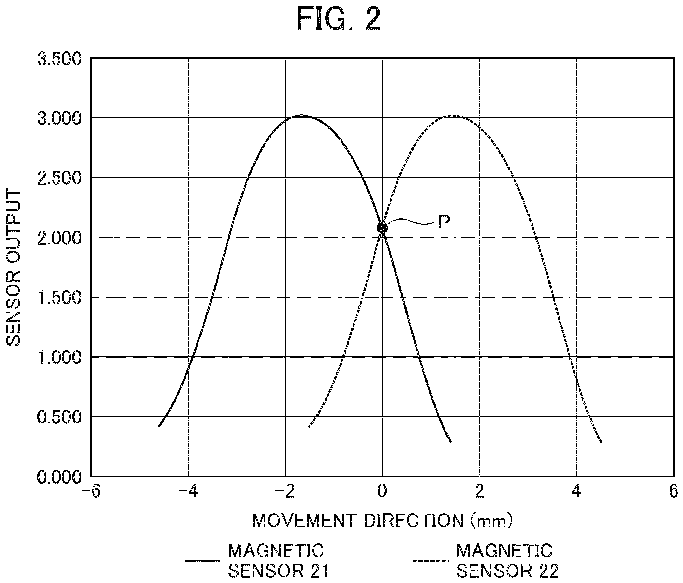

An embodiment of a position detection device according to the present invention is described below with reference to Figs. 1 to 14. In Figs. 1 to 14, the same or corresponding structural elements are given the same reference numerals, and redundant description thereof is omitted. Further, in Figs. 2 to 14, the scales and dimensions of structural elements may be illustrated in an exaggerated manner, and some structural elements may be omitted.

### [1 Basic Structure]

Fig. 1 is a schematic view of the structure of a position detection device 1 according to a first embodiment of the present invention. As illustrated in Fig. 1, the position detection device 1 according to the present embodiment includes a fixed part 10, a pair of magnetic sensors 21, 22 fixed on the fixed part 10, a detection unit 30 connected to the magnetic sensors 21, 22 via a signal line 12, and a magnet 40 mounted to a movable body 2 that is moved by an object to be detected, for example, a tool of a machining center. The movable body 2 is movable in an X direction (first direction) as indicated by an arrow, and the magnet 40 mounted to the movable body 2 is configured so as to move on a movement path M extending along the X direction. The position detection device 1 detects whether or not the movable body 2 (and, by extension, an object to be detected, such as a tool of a machining center) that is movable along the X direction in this way is in a predetermined position (reference line S in Fig. 1).

The magnet 40 has different magnetic poles in a Z direction (second direction). For example, as illustrated in Fig. 1, a magnetic pole 41 of the magnet 40 on the positive side of the Z direction may be the N-pole, and a magnetic pole 42 on the negative side of the Z direction may be the S-pole, or vice versa. Possible shapes of the magnet 40 include a rectangular parallelepiped shape, a cube shape, a cylindrical shape, and a disc shape, etc.

The magnetic sensors 21, 22 detect magnetic fields in the surroundings and have the same sensor characteristics (electric, magnetic, and temperature characteristics). These magnetic sensors 21, 22 are lined up on the fixed part 10 extending in the X direction, and are disposed at positions separated by equal distances, in the Z-direction, from the movement path M on which the magnet 40 moves. The magnetic sensors 21, 22 have sensor surfaces 21A, 22A, each of which is perpendicular to the Z direction. The magnetic sensor 21, 22 are disposed at equal distances from a reference line S extending in the Z direction. In other words, the reference line S is positioned over a midpoint of a line segment connecting the two magnetic sensors 21, 22. As illustrated in Fig. 1, the distance between the two magnetic sensors 21 and 22 is the same as the length L of the magnet 40 in the X direction. Especially when the shape of the magnet 40 is a rectangular parallelepiped shape or a cube shape, the distance between the two magnetic sensors 21 and 22 is the same as the length of the side of the magnet 40 in the X direction. When the shape of the magnet 40 is a cylindrical shape or a disc shape, the distance between the magnetic sensors 21 and 22 is the same as the length of the diameter of the magnet 40. As these magnetic sensors 21, 22, a Hall element, a magnetic modulation sensor, a magnetoresistive element, a SQUID magnetic sensor, etc. may be used.

The detection unit 30 is input with the outputs of the magnetic sensors 21, 22, and includes a comparison circuit that compares the outputs from the magnetic sensors 21, 22. Fig. 2 is a graph illustrating the relationship between the position of the magnet 40 and the outputs of the magnetic sensors 21, 22. In Fig. 2, the output of the magnetic sensor 21 is illustrated by a solid line, and the output of the magnetic sensor 22 is illustrated by a dotted line. The horizontal axis in Fig. 2 represents the distance from the reference line S to the center of the magnet 40, and the vertical axis represents the outputs of the magnetic sensors 21, 22. In this example, the distance between the center of the magnetic sensor 21 in the X direction and the center of the magnetic sensor 22 in the X direction is about 3 mm, and the width of the magnet 40 in the X direction is about 4 mm.

As illustrated in Fig. 2, the sensor outputs of the magnetic sensors 21, 22 become convex according to the position of the magnet 40 in the X direction. The magnetic sensor 21 and the magnetic sensor 22 have the same sensor characteristics, and therefore, when the magnet 40 is positioned at the midpoint of the line segment connecting the magnetic sensor 21 and the magnetic sensor 22, that is to say when the movement distance equals 0 mm (when the magnet 40 is positioned on the reference line S), the outputs of both sensors match each other. In other words, as illustrated in Fig. 2, the point P where the output characteristics of the magnetic sensor 21 and the output characteristics of the magnetic sensor 22 intersect is positioned on the reference line S. Therefore, when the outputs of the magnetic sensor 21 and the magnetic sensor 22 match each other, it can be determined that the magnet 40 is positioned on the reference line S. The detection unit 30 uses this principle and compares the output from the magnetic sensor 21 and the output from the magnetic sensor 22, and determines that the magnet 40 is positioned on the reference line S when both outputs match each other.

Due to this configuration, it can be detected that the magnet 40 is positioned on the reference line S without using mechanical contact points. Thus, the position detection device 1 according to the present embodiment is capable of detecting the position of the movable body 2 without using mechanical contact points. Because no mechanical contact points are used, there are no problems such as the lifespan being shortened and poor conductivity between contact points due to deterioration of the contact points, and the detection precision being reduced due to wear and denting of the contact points.

By disposing the magnetic sensors 21, 22 such that the output change rates of the magnetic sensors 21, 22 are maximum when the magnet 40 is positioned on the reference line S, the outputs of the magnetic sensors 21, 22 easily change when the magnet 40 is in the vicinity of the reference line S, and therefore, the point at which the outputs of the magnetic sensors 21, 22 match each other is more precisely identified. Therefore, the detection precision of the position of the magnet 40 is increased.

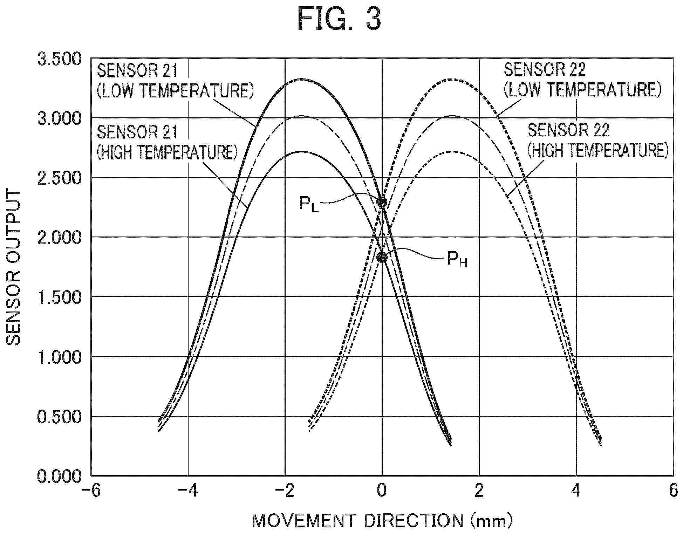

The output characteristics of the magnetic sensors 21, 22 change according to temperature, but because the sensor characteristics of the magnetic sensors 21, 22 are the same, the change in output characteristics of the magnetic sensor 21 and the change in output characteristics of the magnetic sensor 22 cancel each other out even if the output characteristics of the magnetic sensors 21, 22 change according to temperature. Therefore, as illustrated in Fig. 3, a point PL, where the output characteristics of the magnetic sensor 21 at a low temperature and the output characteristics of the magnetic sensor 22 at a low temperature intersect, is on the reference line S, and a point PH, where the output characteristics of the magnetic sensor 21 at a high temperature and the output characteristics of the magnetic sensor 22 at a high temperature intersect, is also on the reference line S. Accordingly, as described above, by determining whether or not the output of the magnetic sensor 21 and the output of the magnetic sensor 22 match each other, it can be stably detected that the magnet 40 is positioned on the reference line S even when the temperature changes. In Fig. 3, the output characteristics of the magnetic sensors 21, 22 illustrated in Fig. 2 are indicated by thin, dotted lines.

Similarly, changes in output characteristics of the magnetic sensor 21 and the changes in output characteristics of the magnetic sensor 22 cancel each other out even if the electric characteristics or magnetic characteristics of the magnetic sensors 21, 22 change, and therefore the position of the magnet 40 can be stably detected. External magnetic fields in the Z direction or a Y direction perpendicular to the paper surface also act on both the magnetic sensor 21 and the magnetic sensor 22 in a similar manner, but because the changes in output characteristics of the magnetic sensor 21 and the changes in output characteristics of the magnetic sensor 22 cancel each other out, the position of the magnet 40 can be stably detected while suppressing the influence of such external magnetic fields. In addition, because changes in output characteristics of the magnetic sensors 21, 22 due to a displacement of the magnet 40 in the Z direction or the Y direction are canceled out, the position of the magnet 40 can be stably detected while suppressing the influence of the displacement of the magnet 40 in the Z direction and the Y direction.

In addition, the outputs of the magnetic sensors 21, 22 may be A-D converted and filtered for noise reduction. Alternatively, noise in the analog outputs of the magnetic sensors 21, 22 may be removed by a low-pass filter.

### [2 Specific Example of Structure]

### [2.1 Size of Magnet]

The magnet 40 and the sensor substrate need to be as small as possible so that they can be fitted in precision instruments. Therefore, the magnet 40 preferably has a size that is equal to or smaller than a square having sides of approximately 5 mm in length, or has a diameter of 5 mm or less. Meanwhile, considering ease of assembly of the position detection device 1, the magnet 40 needs to have a suitable size, and thus the magnet 40 preferably has a size that is equal to or larger than a square having sides of approximately 1.5 mm in length.

### [2.2 Shape of Magnet]

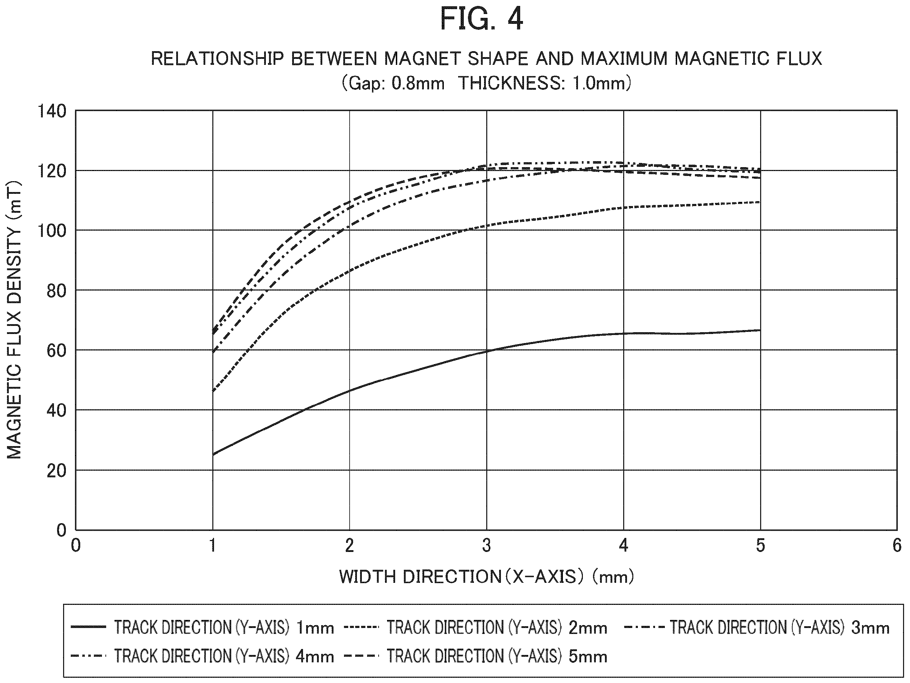

The stronger the magnetic field of the magnet 40, the better the S/N ratio, and the better the repeat precision. As such, a big and thick magnet 40 is desired. It is also desirable that the distance between the magnetic sensor 21 and the magnetic sensor 22 and the magnet 40 is short. Fig. 4 is a graph illustrating the relationship between the shape of the magnet and the maximum magnetic flux when the gap between the magnetic sensor 21 and the magnetic sensor 22 and the magnet 40 is 0.8 mm and the thickness (length in the Z direction) of the magnet 40 is 1.0 mm. The lines in Fig. 4 indicate the length of the magnet 40 in the Y direction. That is to say, Fig. 4 illustrates changes in a magnetic flux density when the length of the magnet 40 in the X direction is changed, in each of the cases wherein the length of the magnet 40 in the Y direction is respectively 1 mm, 2 mm, 3 mm, 4 mm, and 5 mm. As can be seen from the graph in Fig. 4, the magnetic flux density becomes too low when the length of the magnet 40 in the X direction is less than 1.5 mm, but the magnetic flux density does not change greatly even when said length exceeds 3 mm. In other words, the length of the magnet 40 in the X direction is preferably 1.5 to 3 mm. Meanwhile, the length of the magnet 40 in the Y direction is preferably 2 mm to 4 mm.

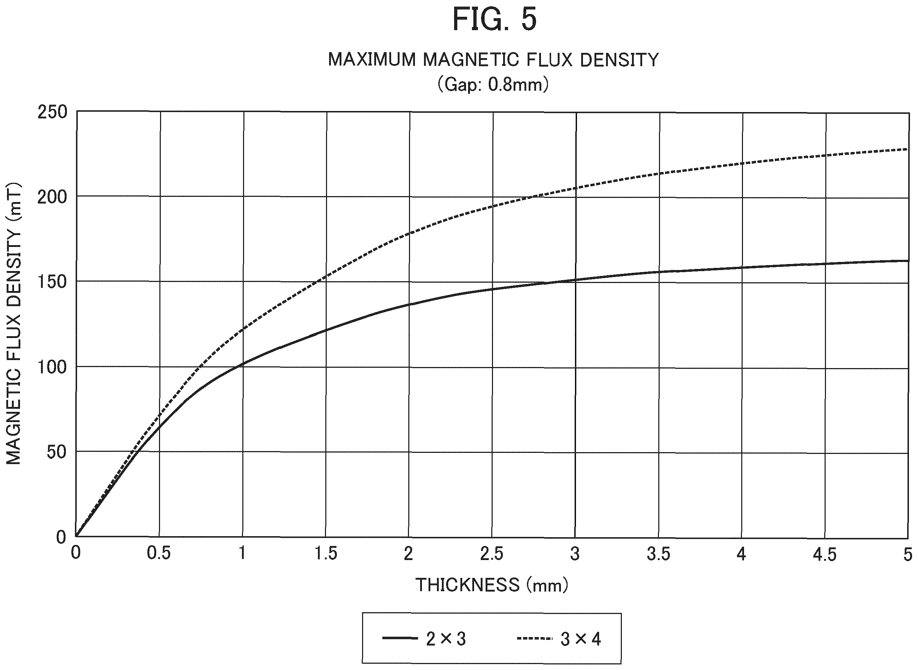

The magnetic field in the magnetization direction of the magnet 40 is substantially proportional to the thickness (length in the Z direction) of the magnet 40, but in order to prevent the shape of an exceedingly thick magnet 40 from becoming too big and to prevent cutting chips from adhering to the magnet, the magnetic shielding must be made strong, and it is therefore desirable to set the thickness of the magnet 40 to a suitable range. Fig. 5 is a graph illustrating the relationship between the length of the magnet 40 in the Z direction (thickness) and magnetic flux density, when the lengths of the magnet 40 in the X direction and the Y direction are respectively 2mm by 3 mm, and 3 mm by 4 mm. As indicated by the graph in Fig. 5, the magnetic flux density becomes too low when the thickness of the magnet 40 is less than 1 mm, but the magnetic flux density value does not change greatly even when said thickness exceeds 3 mm. In other words, the thickness of the magnet 40 is preferably 1 mm to 3 mm.

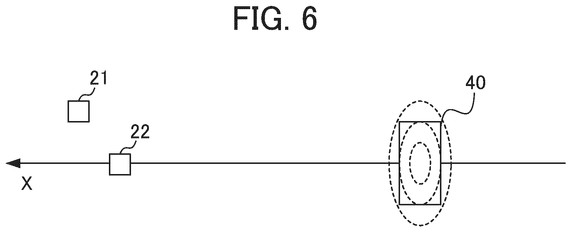

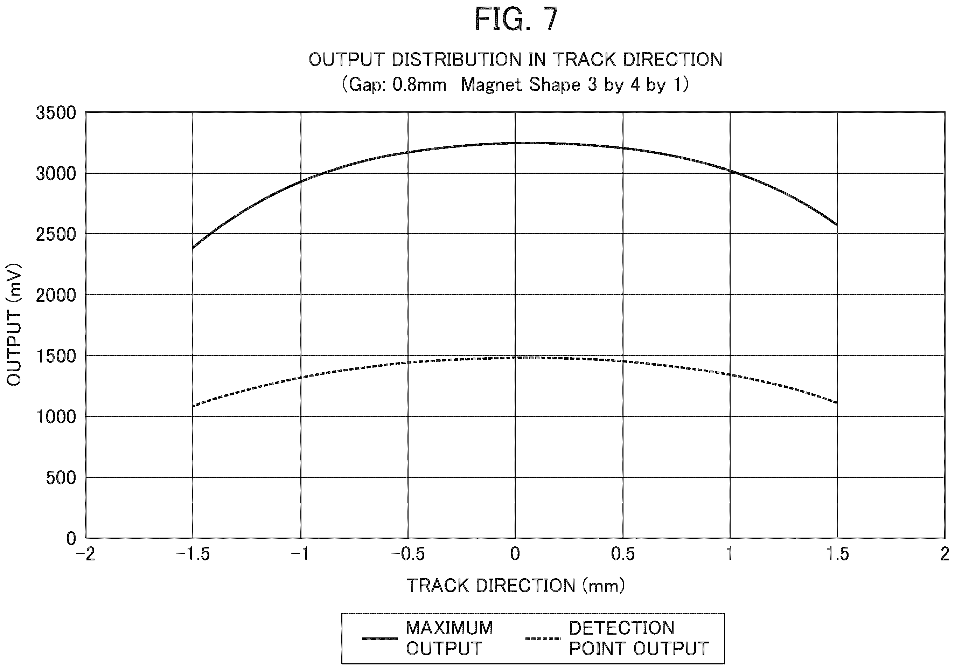

Based on the principle of the position detection device 1 including the magnetic sensor 21 and the magnetic sensor 22 used in the present embodiment, positioning precision in the X direction does not depend on track displacement of the magnetic sensor 21 and the magnetic sensor 22, but when a mounting error of the magnetic sensor 21 and the magnetic sensor 22 occurs, the track displacement causes a position error to occur. At this time, when a small and round or rectangular magnet is used as the magnet 40, attenuation of the magnetic field from the track, or the X-axis, toward the Y-axis becomes greater, whereby the S/N ratio easily drops and origin position displacement easily occurs. Therefore, the magnet 40 is preferably of a rectangular shape where the longitudinal direction is in the Y direction. Fig. 6 illustrates the positional relationship between a track displacement of the magnetic sensor 21 and the magnetic sensor 22 and the magnet 40, when the magnet 40 has a rectangular shape. As illustrated in Fig. 6, the magnetic field of the magnet 40 has an elliptical shape with the Y direction as the longitudinal direction, and therefore the influence of track displacement is small. Fig. 7 is a graph illustrating the relationship between the displacement of the magnetic sensor 21 and the magnetic sensor 22 in the track direction and the output distribution, when the gap between the magnetic sensor 21 and the magnetic sensor 22 and the magnet 40 is 0.8 mm, and the lengths of the magnet 40 in the X direction, the Y direction, and the Z direction are respectively 3 mm, 4 mm, and 1 mm. The magnet 40 has a rectangular shape where the longitudinal direction is the Y direction, and in this case, even when the displacement in the track direction is 0.3 mm, the attenuation rate of the output is within a range of 2%. In view of this, it can be seen that the magnet 40 preferably has a rectangular shape where the longitudinal direction is the Y direction.

### [2.3 Material of Magnet]

The magnet 40 is preferably made of a material that is strong, is not susceptible to rusting, and has a favorable temperature coefficient. More specifically, a samarium-cobalt magnet having a temperature coefficient of -0.03%/°C, or a rust-proofed neodymium magnet having a temperature coefficient of -0.13%/°C, is preferable.

### [2.4 Spacing of Magnetic Sensors]

When the pair of the magnetic sensor 21 and the magnetic sensor 22 are surface-mounted, the magnetic sensor 21 and the magnetic sensor 22 are preferably spaced apart by approximately 1.5 mm or more.

### [2.5 Relationship between Magnet and Magnetic Sensors]

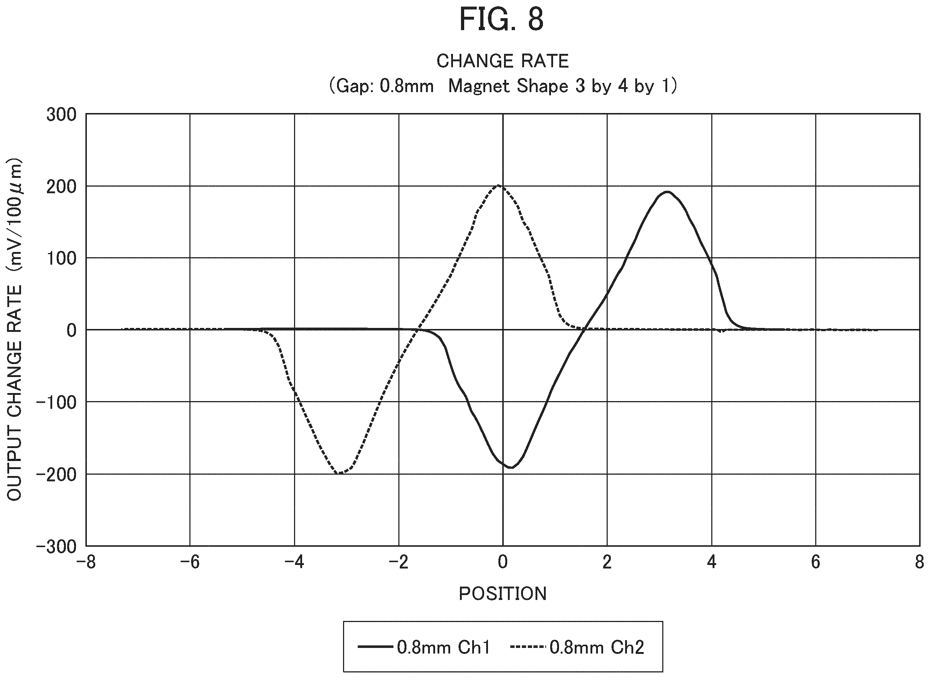

The length of the magnet 40 in the X direction that allows for a maximum change rate of the outputs of the pair of the magnetic sensor 21 and the magnetic sensor 22 to be obtained is equal to the mounting distance between the magnetic sensor 21 and the magnetic sensor 22, and therefore, as described above, when the magnetic sensor 21 and the magnetic sensor 22 are spaced apart by approximately 1.5 mm or more, the length of the magnet 40 in the X direction is preferably also approximately 1.5 mm or more. Fig. 8 is a graph illustrating a relationship between the position of the magnet 40 and the output change rates of the magnetic sensor 21 and the magnetic sensor 22, when the gap between the pair of the magnetic sensor 21 and the magnetic sensor 22 and the magnet 40 is 0.8 mm, and the lengths of the magnet in the X direction, the Y direction, and the Z direction are respectively 3 mm, 4 mm, and 1 mm, and the length of the magnet 40 in the X direction is substantially equal to the mounting distance between the magnetic sensor 21 and the magnetic sensor 22. As illustrated in Fig. 8, when the position of the magnet 40 is 0, that is to say when the magnet 40 is positioned on the reference line, both of the absolute values of the output change rates of the magnetic sensor 21 and the magnetic sensor 22 are substantially maximum.

The distance (gap) between the pair of the magnetic sensor 21 and the magnetic sensor 22 and the magnet 40 is determined by repeat precision, component precision, assembly precision, ease of assembly checking, etc. Specifically, it is determined with consideration to the required values of, for example, ±0.1 mm as the component precision, 0.2 mm as the mounting precision, and 0.1 mm or less as mechanical variation, that is to say, variations due to play in the shaft, etc. As a result, the distance (gap) between the pair of the magnetic sensors 21 and the magnet 40 is preferably 0.3 mm to 0.8 mm.

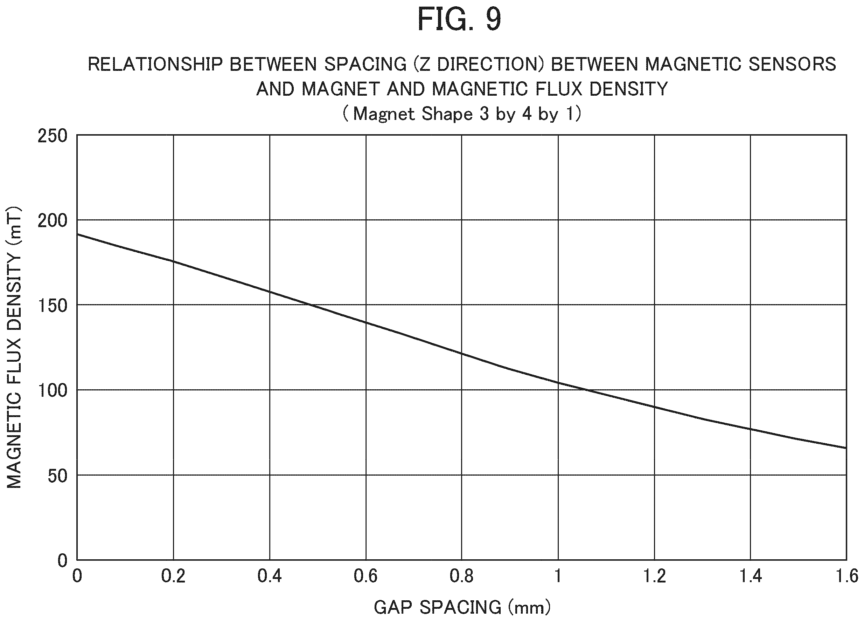

Fig. 9 is a graph illustrating the relationship between the distance (gap) between the pair of the magnetic sensor 21 and the magnetic sensor 22 and the magnet 40, and the magnetic flux density. When the distance (gap) is 0.3 mm to 0.8 mm, the magnetic flux density becomes generally 120 mT to 170 mT.

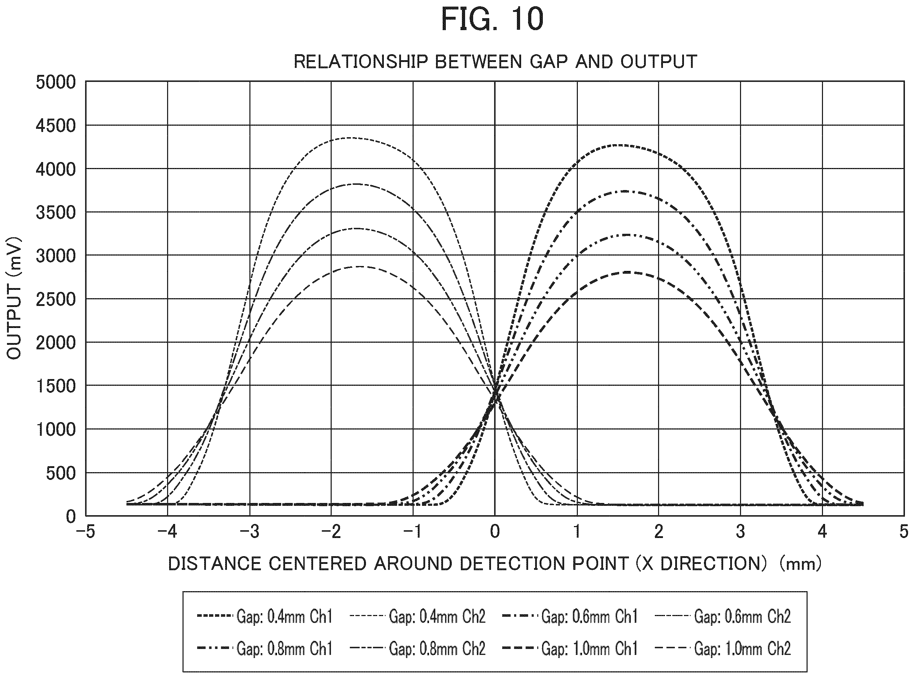

Fig. 10 is a graph illustrating the relationship between a distance in the X direction centered on a detection point and the outputs, in cases where the distance (gap) between the pair of the magnetic sensor 21 and the magnetic sensor 22 and the magnet 40 is respectively 0.4 mm, 0.6 mm, 0.8 mm, and 1.0 mm. In the graph of Fig. 10, "Ch1" indicates the output of the magnetic sensor 21, and "Ch2" indicates the output of the magnetic sensor 22. As can be seen from Fig. 10, it is indicated that in the graph wherein the distance (gap) between the pair of the magnetic sensor 21 and the magnetic sensor 22 and the magnet 40 is 1.0 mm, the output is smaller compared to the other graphs.

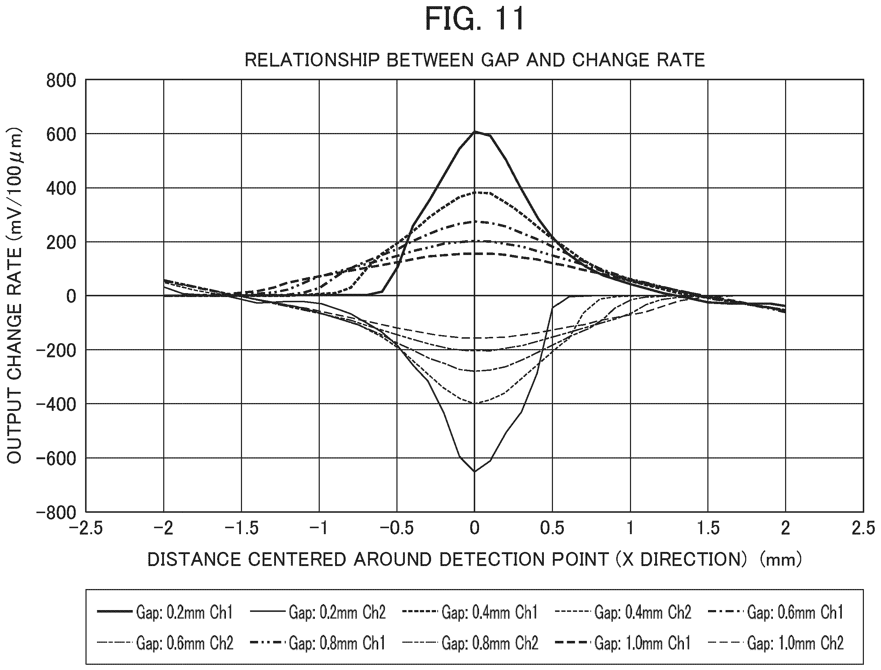

Fig. 11 is a graph illustrating the relationship between a distance in the X direction centered on a detection point and an actual value of the output change rate, in cases where the distance (gap) between the pair of the magnetic sensor 21 and the magnetic sensor 22 and the magnet 40 is respectively 0.4 mm, 0.6 mm, 0.8 mm, and 1.0 mm. In the graph of Fig. 11, "Ch1" indicates the output change rate of the magnetic sensor 21, and "Ch2" indicates the output change rate of the magnetic sensor 22. As can be seen from Fig. 10, it is indicated that in the graph wherein the distance (gap) between the pair of the magnetic sensor 21 and the magnetic sensor 22 and the magnet 40 is 1.0 mm, the absolute value of the output change rate is smaller compared to the other graphs.

### [Usage Example of Internal Data]

By monitoring the magnetic force data (sensor data) that is the internal data of the position detection device **1,** the state of the pair of the magnetic sensor 21 and the magnetic sensor 22 can be comprehended, allowing for a fault diagnosis of the position detection device 1. More specifically, by monitoring the internal data, it is possible to diagnose a maintenance time for the position detection device **1,** diagnose faults in the pair of the magnetic sensor 21 and the magnetic sensor 22, and diagnose the operating environment of the position detection device 1.

In order to diagnose the maintenance time, it is effective to use the internal data to get a grasp on return failures due to adhesion and accumulation of cutting chips or cutting fluid on the sliding parts of the position detection device **1,** and to get a grasp on the number of operations. In order to diagnose faults in the pair of the magnetic sensor 21 and the magnetic sensor 22, it is effective to get a grasp on return failures due to adhesion of cutting chips or cutting fluid, internal negative pressure, and deterioration of bearings, and to get a grasp on detent damage caused by impacts. In order to diagnose the operating environment, it is effective to get a grasp on return failure caused by a negative pressure in the interior of the position detection device 1 due to, for example, a change in the surrounding temperature, and to get a grasp on deterioration of bearings caused by machining vibrations, impacts due to pallet changes, mounting or removal of workpieces, impacts due to clamping/unclamping, and impacts due to removal of the device from storage.

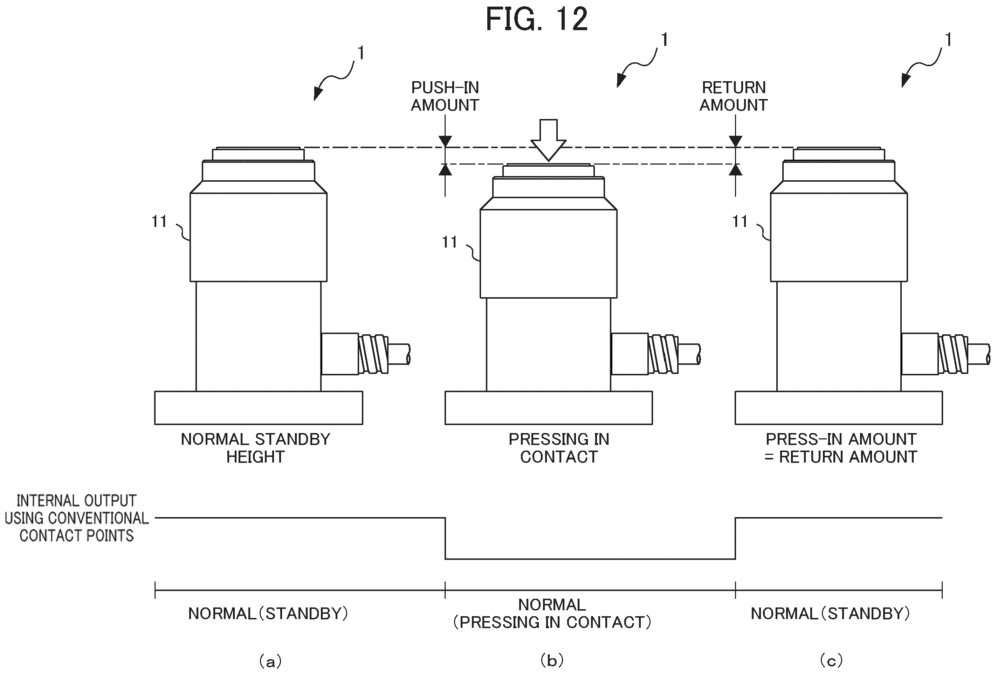

A method for detecting return failure and deterioration of bearings is described below with reference to Fig. 12 to Fig. 14.

Fig. 12 illustrates an internal output using conventional contact points, wherein a contact 11 returns after being pushed in.

In Fig. 12, as indicated by numeral (a), the contact 11 is at a normal standby height during standby. Next, as indicated by numeral (b), the contact 11 is pushed in. Thereafter, when the load on the contact 11 is released, the contact 11 returns to the original position as indicated by numeral (c). At this time, the standby height of the contact 11 at (a) and the standby height of the contact 11 at (c) are equal, and thus the push-in amount of the contact 11 when going from (a) to (b) and the return amount of the contact 11 when going from (b) to (c) are equal. Further, regarding the value of the internal sensor, the value before pushing in the contact 11 and the value after the contact 11 has returned after being pushed in are equal.

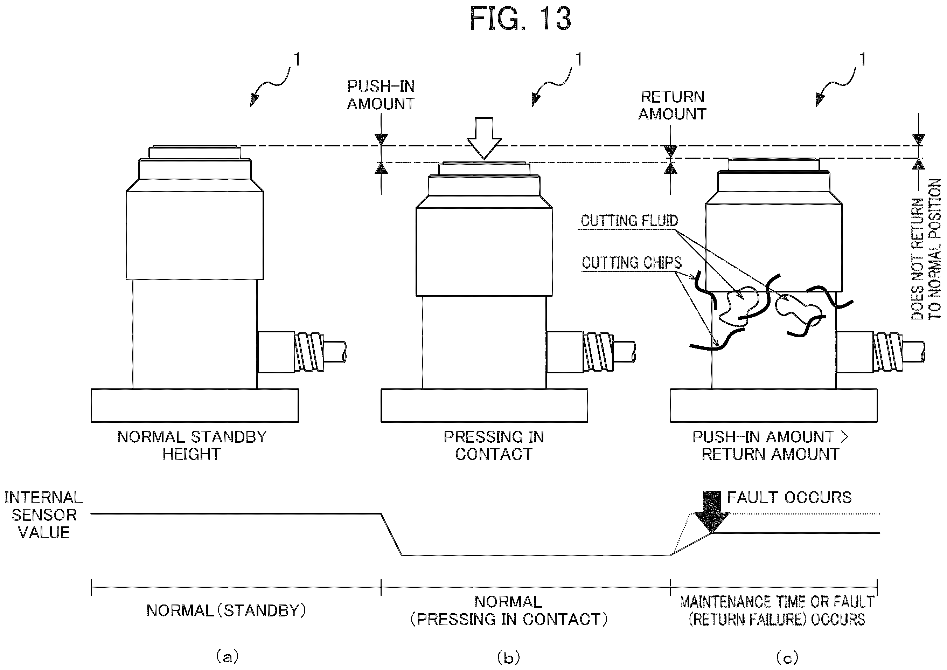

Fig. 13 illustrates a change in an internal sensor value as internal data when the position detection device 1 is in an abnormal state due to a return failure. In the example illustrated in Fig. 13, as indicated by numeral (c), cutting fluid and cutting chips have adhered to a region where the contact 11 of the position detection device 1 slides. Therefore, when going from (b) to (c), the contact 11 cannot return to the normal position. Accordingly, the return amount of the contact 11 when going from (b) to (c) is smaller than the push-in amount of the contact 11 when going from (a) to (b). Further, regarding the value of the internal sensor, the value after the contact 11 has returned after being pushed in is smaller than the value before pushing in the contact 11.

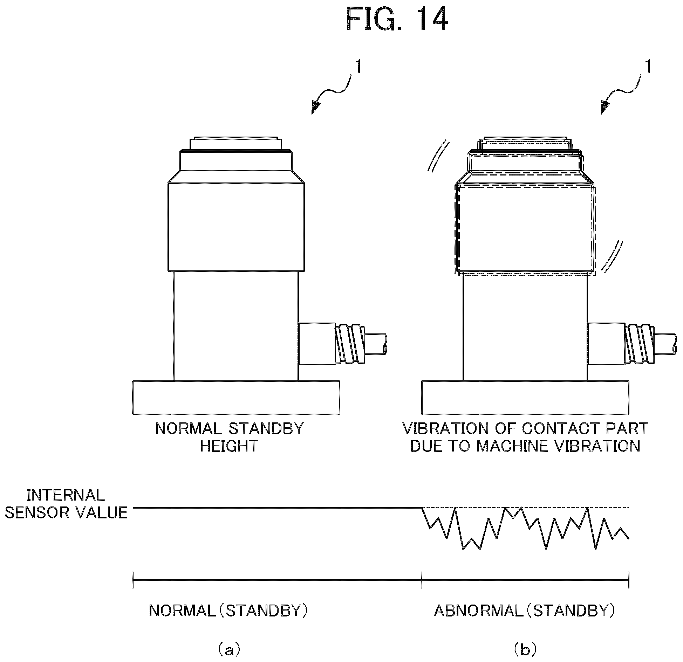

Fig. 14 illustrates an internal sensor value as internal data when the position detection device 1 is in an abnormal state due to a deteriorated bearing. As indicated by numeral (a), during normal standby, the value of the internal sensor does not fluctuate. On the other hand, when the bearing has deteriorated, when a machining vibration and a vibration due to mounting or removal of a workpiece, a vibration when moving the sensor into or out of storage, or an impact due to a pallet change has occurred, the contact 11 vibrates accordingly, and, as indicated by numeral (b), the value of the internal sensor fluctuates.

Therefore, the position detection device 1 may further include a comparison unit (not illustrated) that compares the outputs of the magnetic sensor 21 and the magnetic sensor 22 during standby of the position detection device 1 with the outputs of the magnetic sensor 21 and the magnetic sensor 22 when the magnet 40 has been moved in the X direction and then returned in the direction opposite to the X direction, and a first diagnosis unit (not illustrated) that diagnoses an abnormality of the position detection device 1 on the basis of the comparison results from the comparison unit.

In addition, the position detection device 1 may further include a second diagnosis unit (not illustrated) that diagnoses an abnormality of the position detection device 1 on the basis of the waveforms of the outputs of the magnetic sensor 21 and the magnetic sensor 22 during standby of the position detection device 1.

### [4 Effects of the Embodiment]

As described above, an aspect of the present invention provides a position detection device that can stably detect a position with high detection precision over a long lifespan. This position detection device is provided with a magnet configured to move, together with a movable body, on a movement path extending along a first direction. The magnet has different magnetic poles in a second direction that is perpendicular to the first direction. The position detection device is provided with a pair of magnetic sensors that are separated by equal distances, in the second direction, from the movement path, and that are disposed at equal distances from a reference line extending in the second direction. The pair of magnetic sensors have the same sensor characteristics. The position detection device is provided with a detection unit configured to detect that the magnet is positioned on the reference line in a state where the absolute values of the output change rates of both of the pair of magnetic sensors are substantially maximum.

This allows for detecting that the magnet is positioned on the reference line without using mechanical contact points. Thus, the position detection device according to the present invention is capable of detecting the position of the movable body without using mechanical contact points. The position detection device according to the present invention thus does not use any mechanical contact points, and therefore, there are no problems such as the lifespan being shortened or poor conductivity between contact points due to deterioration of the contact points, or the detection precision being reduced due to wear and denting of the contact points. In addition, changes in output characteristics of the pair of magnetic sensors due to temperature changes cancel each other out, and therefore, the position of the magnet can be stably detected.

The outputs of the pair of magnetic sensors preferably exhibit the maximum change rates when the magnet is positioned on the reference line. According to this configuration, the outputs of the magnetic sensors easily change when the magnet is in the vicinity of the reference line, and therefore, the point at which the outputs of the magnetic sensors match each other is more precisely identified, and detection precision of the position of the magnet is increased.

The present invention provides a position detection device that can stably detect a position with high detection precision over a long lifespan.

In addition, the present invention provides a position detection device capable of fault diagnosis and predictive maintenance.

### [Industrial Applicability]

The present invention is preferably used in a position detection device for detecting a position of a movable body.

### EXPLANATION OF REFERENCE NUMERALS

1 Position detection device
2 Movable body
10 Fixed part
21, 22 Magnetic sensor
30 Detection unit
40 Magnet
41, 42 Magnetic pole
M Movement path
S Reference line

## Claims

1. A position detection device (1) comprising:
a magnet (40) configured to move, together with a movable body (2), on a movement path (M) extending along a first direction (X), the magnet (40) having different magnetic poles (41, 42) in a second direction (Z) that is perpendicular to the first direction (X);
a pair of magnetic sensors (21, 22) that are separated by equal distances, in the second direction (Z), from the movement path (M), and that are disposed at equal distances from a reference line (S) extending in the second direction (Z), the pair of magnetic sensors (21, 22) having identical sensor characteristics; and
a detection unit (30) configured to detect that the magnet (40) is positioned on the reference line (S) in a state where absolute values of output change rates of both of the pair of magnetic sensors (21, 22) are maximum, wherein a distance between the pair of magnetic sensors(21, 22) and the length (L) of the magnet (40) in the first direction (X) are equal.

2. The position detection device (1) according to claim 1, wherein the length of the magnet (40) in the first direction (X) is approximately 1.5 mm or more.

3. The position detection device (1) according to claim 1 or 2, wherein the length of the magnet (40) in the first direction (X) is approximately 1.5 mm to 3 mm, and the length of the magnet in the second direction (Z) is approximately 2 mm to 4 mm.

4. The position detection device (1) according to any one of claims 1 to 3, wherein a length of the magnet (40) in a third direction perpendicular to the first direction (X) and the second direction (Z) is approximately 1 mm to 3 mm.

5. The position detection device (1) according to any one of claims 1 to 4, wherein the magnet (40) has a rectangular parallelepiped shape, the rectangular parallelepiped shape having axes of symmetry that match in the first direction (X) and the second direction (Z).

6. The position detection device (1) according to any one of claims 1 to 5, wherein the pair of magnetic sensors (21, 22) are spaced apart by approximately 1.5 mm or more in the first direction (X).

7. The position detection device (1) according to any one of claims 1 to 6, wherein a distance between a central axis of the movement path (M) of the magnet (40) and the pair of magnetic sensors (21, 22) is approximately 0.3 mm to 0.8 mm.

8. The position detection device (1) according to any one of claims 1 to 7, wherein the magnet (40) is a samarium-cobalt magnet, or a neodymium magnet that has been rust-proofed.

9. The position detection device (1) according to any one of claims 1 to 8, further comprising:
a comparison unit that compares outputs of the magnetic sensors (21, 22) during standby of the position detection device (1) with outputs of the magnetic sensors (21, 22) when the magnet (40) has been moved in the first direction (X) and then returned in a direction opposite to the first direction (X); and
a first diagnosis unit that diagnoses an abnormality of the position detection device (1) on the basis of comparison results from the comparison unit.

10. The position detection device (1) according to any one of claims 1 to 8, further comprising a second diagnosis unit that diagnoses an abnormality of the position detection device on the basis of fluctuation in a value of the outputs of the magnetic sensors (21, 22) due to vibration during standby of the position detection device (1).

## Patentansprüche

1. Eine Positionsdetektionsvorrichtung (1), umfassend:
einen Magneten (40), der eingerichtet ist, sich gemeinsam mit einem beweglichen Körper (2) entlang eines Bewegungswegs (M) in einer ersten Richtung (X) zu bewegen, wobei der Magnet (40) unterschiedliche magnetische Pole (41, 42) in einer zweiten Richtung (Z) aufweist, die senkrecht zur ersten Richtung (X) verläuft;
ein Paar magnetischer Sensoren (21, 22), die in der zweiten Richtung (Z) in gleichen Abständen vom Bewegungsweg (M) beabstandet sind und in gleichen Abständen von einer in der zweiten Richtung (Z) verlaufenden Referenzlinie (S) angeordnet sind, wobei das Paar magnetischer Sensoren (21, 22) identische Sensoreigenschaften aufweist; und
eine Detektionseinheit (30), die eingerichtet ist, zu detektieren, dass sich der Magnet (40) auf der Referenzlinie (S) befindet, in einem Zustand, in dem Absolutwerte von Ausgabesänderungsraten beider magnetischer Sensoren (21, 22) maximal sind, wobei ein Abstand zwischen dem Paar magnetischer Sensoren (21, 22) und die Länge (L) des Magneten (40) in der ersten Richtung (X) gleich sind.

2. Die Positionsdetektionsvorrichtung (1) gemäß Anspruch 1, wobei die Länge des Magneten (40) in der ersten Richtung (X) ungefähr 1,5 mm oder mehr beträgt.

3. Die Positionsdetektionsvorrichtung (1) gemäß einem der Ansprüche 1 oder 2, wobei die Länge des Magneten (40) in der ersten Richtung (X) ungefähr 1,5 mm bis 3 mm beträgt, und die Länge des Magneten (40) in der zweiten Richtung (Z) ungefähr 2 mm bis 4 mm beträgt.

4. Die Positionsdetektionsvorrichtung (1) gemäß einem der Ansprüche 1 bis 3, wobei eine Länge des Magneten (40) in einer dritten Richtung, die senkrecht zur ersten Richtung (X) und zur zweiten Richtung (Z) ist, ungefähr 1 mm bis 3 mm beträgt.

5. Die Positionsdetektionsvorrichtung (1) gemäß einem der Ansprüche 1 bis 4, wobei der Magnet (40) eine rechteckige quaderförmige Gestalt aufweist, wobei die rechteckige quaderförmige Gestalt Symmetrieachsen aufweist, die in der ersten Richtung (X) und in der zweiten Richtung (Z) übereinstimmen.

6. Die Positionsdetektionsvorrichtung (1) gemäß einem der Ansprüche 1 bis 5, wobei das Paar magnetischer Sensoren (21, 22) in der ersten Richtung (X) um ungefähr 1,5 mm oder mehr voneinander beabstandet ist.

7. Die Positionsdetektionsvorrichtung (1) gemäß einem der Ansprüche 1 bis 6, wobei ein Abstand zwischen einer Mittelachse des Bewegungswegs (M) des Magneten (40) und dem Paar magnetischer Sensoren (21, 22) ungefähr 0,3 mm bis 0,8 mm beträgt.

8. Die Positionsdetektionsvorrichtung (1) gemäß einem der Ansprüche 1 bis 7, wobei der Magnet (40) ein Samarium-Kobalt-Magnet oder ein gegen Rost geschützter Neodym-Magnet ist.

9. Die Positionsdetektionsvorrichtung gemäß einem der Ansprüche 1 bis 8, ferner umfassend:
eine Vergleichseinheit, die Ausgaben der magnetischen Sensoren (21, 22) während des Bereitschaftszustands der Positionsdetektionsvorrichtung (1) mit Ausgaben der magnetischen Sensoren (21, 22) vergleicht, wenn der Magnet (40) in der ersten Richtung (X) bewegt und dann in eine der ersten Richtung (X) entgegengesetzte Richtung zurückgeführt wurde; und
eine erste Diagnoseeinheit, die eine Anomalie der Positionsdetektionsvorrichtung (1) auf Basis von Vergleichsergebnissen der Vergleichseinheit diagnostiziert.

10. Die Positionsdetektionsvorrichtung gemäß einem der Ansprüche 1 bis 8, ferner umfassend eine zweite Diagnoseeinheit, die eine Anomalie der Positionsdetektionsvorrichtung auf Basis von Schwankungen eines Werts der Ausgaben der magnetischen Sensoren (21, 22) infolge von Vibrationen während des Bereitschaftszustands der Positionsdetektionsvorrichtung (1) diagnostiziert.

## Revendications

1. Dispositif de détection de position (1) comprenant :
un aimant (40) conçu pour se déplacer, conjointement avec un corps mobile (2), sur un trajet de déplacement (M) s'étendant le long d'une première direction (X), l'aimant (40) présentant des pôles magnétiques (41, 42) différents dans une deuxième direction (Z) qui est perpendiculaire à la première direction (X) ;
une paire de capteurs magnétiques (21, 22) qui sont séparés par des distances égales, dans la deuxième direction (Z), de la trajectoire de mouvement (M), et qui sont disposés à des distances égales d'une ligne de référence (S) s'étendant dans la deuxième direction (Z), la paire de capteurs magnétiques (21, 22) présentant des caractéristiques de capteur identiques ; et
une unité de détection (30) conçue pour détecter que l'aimant (40) est positionné sur la ligne de référence (S) dans un état où des valeurs absolues des vitesses de changement de sortie des deux paires de capteurs magnétiques (21, 22) sont maximales, dans lequel une distance entre la paire de capteurs magnétiques (21, 22) et la longueur (L) de l'aimant (40) dans la première direction (X) sont égales.

2. Dispositif de détection de position (1) selon la revendication 1, dans lequel la longueur de l'aimant (40) dans la première direction (X) est d'environ 1,5 mm ou plus.

3. Dispositif de détection de position (1) selon la revendication 1 ou 2, dans lequel la longueur de l'aimant (40) dans la première direction (X) est d'environ 1,5 mm à 3 mm, et la longueur de l'aimant dans la deuxième direction (Z) est d'environ 2 mm à 4 mm.

4. Dispositif de détection de position (1) selon l'une quelconque des revendications 1 à 3, dans lequel une longueur de l'aimant (40) dans une troisième direction perpendiculaire à la première direction (X) et la deuxième direction (Z) est d'environ 1 mm à 3 mm.

5. Dispositif de détection de position (1) selon l'une quelconque des revendications 1 à 4, dans lequel l'aimant (40) présente une forme de parallélépipède rectangle, la forme de parallélépipède rectangle présentant des axes de symétrie qui correspondent dans la première direction (X) et la deuxième direction (Z).

6. Dispositif de détection de position (1) selon l'une quelconque des revendications 1 à 5, dans lequel la paire de capteurs magnétiques (21, 22) est espacée d'environ 1,5 mm ou plus dans la première direction (X).

7. Dispositif de détection de position (1) selon l'une quelconque des revendications 1 à 6, dans lequel une distance entre un axe central de la trajectoire de mouvement (M) de l'aimant (40) et la paire de capteurs magnétiques (21, 22) est d'environ 0,3 mm à 0,8 mm.

8. Dispositif de détection de position (1) selon l'une quelconque des revendications 1 à 7, dans lequel l'aimant (40) est un aimant samarium-cobalt, ou un aimant néodyme qui a été protégé contre la rouille.

9. Dispositif de détection de position (1) selon l'une quelconque des revendications 1 à 8, comprenant en outre :
une unité de comparaison qui compare des sorties des capteurs magnétiques (21, 22) pendant la veille du dispositif de détection de position (1) à des sorties des capteurs magnétiques (21, 22) lorsque l'aimant (40) a été déplacé dans la première direction (X) puis retourné dans une direction opposée à la première direction (X) ; et
une première unité de diagnostic qui diagnostique une anomalie du dispositif de détection de position (1) sur la base de résultats de comparaison de l'unité de comparaison.

10. Dispositif de détection de position (1) selon l'une quelconque des revendications 1 à 8, comprenant en outre une seconde unité de diagnostic qui diagnostique une anomalie du dispositif de détection de position sur la base d'une fluctuation d'une valeur des sorties des capteurs magnétiques (21, 22) en raison de vibrations pendant la mise en veille du dispositif de détection de position (1).
